# EUROPEAN PATENT APPLICATION

(11) **EP 4 498 640 A1**
(43) Date of publication of application: **29.01.2025**
(21) Application number: 24188619.1
(22) Date of filing: 15.07.2024
(51) Int. Cl.: H04L 12/10, H04L 12/40, H04L 67/12

(54) **INTELLIGENT ELECTRONIC DEVICE APPARATUSES, METHODS AND SYSTEMS**

(30) Priority: 25.07.2023 US 202363528813 P; 14.11.2023 IN 202314077489; 18.01.2024 US 202418416424
(71) Applicant: Schneider Electric USA, Inc., Boston, MA 02108 (US)
(72) Inventor: STEVENSON, Thomas S., BOSTON, 02108 (US); SCHUBERT, Clifford, BOSTON, 02108 (US); ANDERSON, David P., BOSTON, 02108 (US); SAIT J, Mohamed, BOSTON, 02108 (US)
(74) Representative: Plasseraud IP

(57) **Abstract**

In one embodiment, an IED apparatus is described. The IED apparatus includes (a) power system equipment; (b) a first Ethernet port configured to connect to a monitoring server over one of optical fiber cable or multiple-twisted-pair copper cable (MTPCC); (c) a second Ethernet port configured to connect to a remote sensor device over a single-twisted-pair copper cable (STPCC) using the 10Base-T1S or -T1L standard; and (d) processing circuitry configured to (1) communicate monitoring data with the monitoring server over the first Ethernet port and (2) receive sensor information from the remote sensor device via the second Ethernet port over the STPCC using the 10Base-T1S or -T1L standard. A related system is also described.

## Description

### CROSS REFERENCE TO RELATED APPLICATIONS

This application claims priority under 35 U.S.C. § 119(a) to Indian Patent Application No. 202314077489, titled "10BASE-T1S AND -T1L ON POWER MONITORING AND PROTECTION EQUIPMENT," filed on November 14, 2023, which claims priority to U.S. Provisional Patent Application Serial No. 63/528,813, titled "10BASE-T1S ON POWER MONITORING AND PROTECTION EQUIPMENT," filed July 25, 2023. This application also claims priority under 35 U.S.C. § 119(e) to U.S. Provisional Patent Application Serial No. 63/528,813, titled "10BASE-T1S ON POWER MONITORING AND PROTECTION EQUIPMENT," filed July 25, 2023.

### BACKGROUND

Power meters are used to monitor and report energy usage and power quality. Protective relays can also monitor energy usage and be configured to trip a circuit breaker in response to detecting certain types of problems. Both power meters and protective relays may include processing circuitry to allow for intelligent monitoring of powered devices; collectively these are referred to as intelligent electronic devices (IEDs). Typical IEDs include a network connection to allow reporting of energy usage across a network connection, as well as one or more serial ports to connect to one or more sensing devices that provide measurements about one or more electrical connections and/or energy usage. These IEDs may then process the received measurements and perform various functions such as data analysis and feedback, storage, and forwarding of either the measurements or the analyzed data across the network connection.

### BRIEF DESCRIPTION OF THE DRAWINGS

The foregoing and other objects, features, and advantages will be apparent from the following description of particular embodiments of the invention, as illustrated in the accompanying drawings in which like reference characters refer to the same parts throughout the different views. The drawings are not necessarily to scale, emphasis instead being placed upon illustrating the principles of various embodiments of the invention. In the figures:
Fig. 1A illustrates an example system and apparatuses for use in connection with one or more embodiments.
Figs. 1B-1C each illustrate an example system and apparatuses for use in connection with one or more other embodiments.
Fig. 2 illustrates an example method for use in connection with one or more embodiments.

### DETAILED DESCRIPTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items.

References to "or" may be construed as inclusive so that any terms described using "or" may indicate any of a single, more than one, and all of the described terms. In addition, in the event of inconsistent usages of terms between this document and documents incorporated herein by reference, the term usage in the incorporated features is supplementary to that of this document; for irreconcilable differences, the term usage in this document controls.

Conventional IEDs, as described above, may suffer from various limitations. For example, communicating with sensing devices exclusively using serial connections may be slow and error-prone. Furthermore, discovery of serial devices may be difficult.

In order to overcome these limitations, IEDs may instead be configured to communicate with new sensor devices using the 10Base-T1S Ethernet standard over single-twisted-pair copper cable (STPCC) (or, in some embodiments, 10Base-T1L or another STPCC-based standard). This standard allows for increased speeds up to 10 Mbps with increased reliability while also providing the ability to perform automatic discovery and configuration. Standard Ethernet using multiple-twisted-pair copper cable (MTPCC) (e.g., Cat. 5, 5e, or 6 cable) would not be suitable, because such cabling takes up more space and is more expensive. In addition, T1S Ethernet also provides improved auto-discovery features.

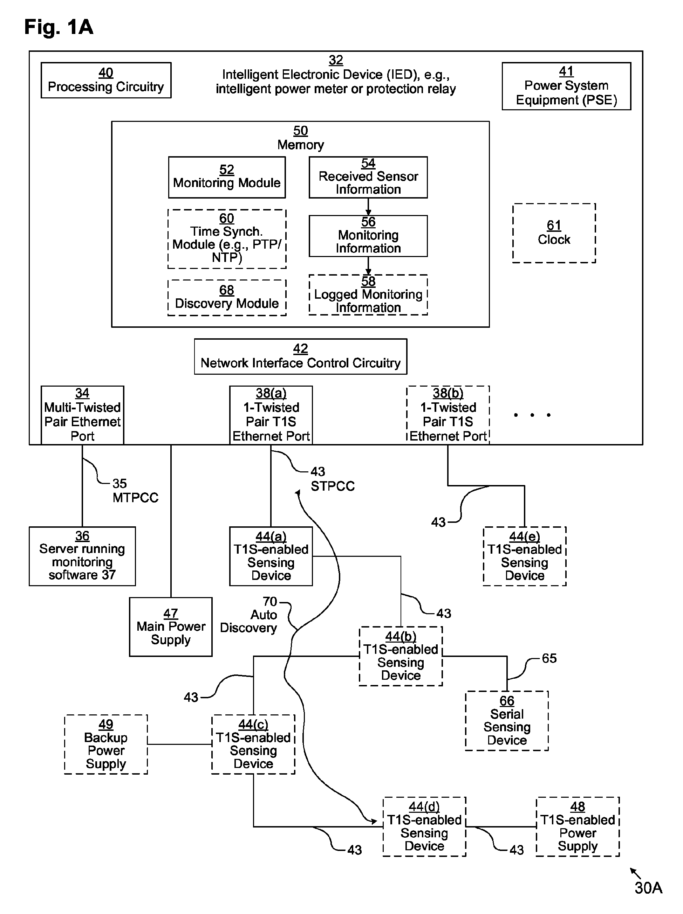

Fig. 1A depicts an example system 30A for use in connection with various embodiments. System 30 includes an intelligent electronic device (IED) 32, such as, for example, an intelligent power meter or an intelligent protective relay. In some embodiments, instead of performing power monitoring, IED 32 may perform monitoring of water, air, gas, steam, and/or any other measurable utility. System 30 also includes a monitoring server 36 (e.g., a supervisory control and data acquisition (SCADA) device, cloud/analytics device, etc.) running power monitoring software 37 and at least one T1S-enabled sensing device 44 (depicted as T1S-enabled sensing device 44(a)). Server 36 connects to IED 32 via MTPCC 35 using Ethernet (e.g., a 100BaseT or faster protocol), and the at least one T1S-enabled sensing device 44(a) connects to IED 32 via STPCC 43. In some embodiments (not depicted), one or more hubs, switches, routers, etc. may interpose between server 36 and IED 32 and/or between the at least one T1S-enabled sensing device 44(a) and IED 32. IED 32 is powered by at least one main power supply 47. In some embodiments, (not depicted), instead of server 36 being connected to IED 32 via MTPCC 35, server 36 may be connected to IED 32 over coaxial or fiber-optical cable or over another connection such as a wireless link. In some embodiments, (not depicted), multiple servers 36 may be connected to IED 32 via multiple MTPCCs 35 or other connections.

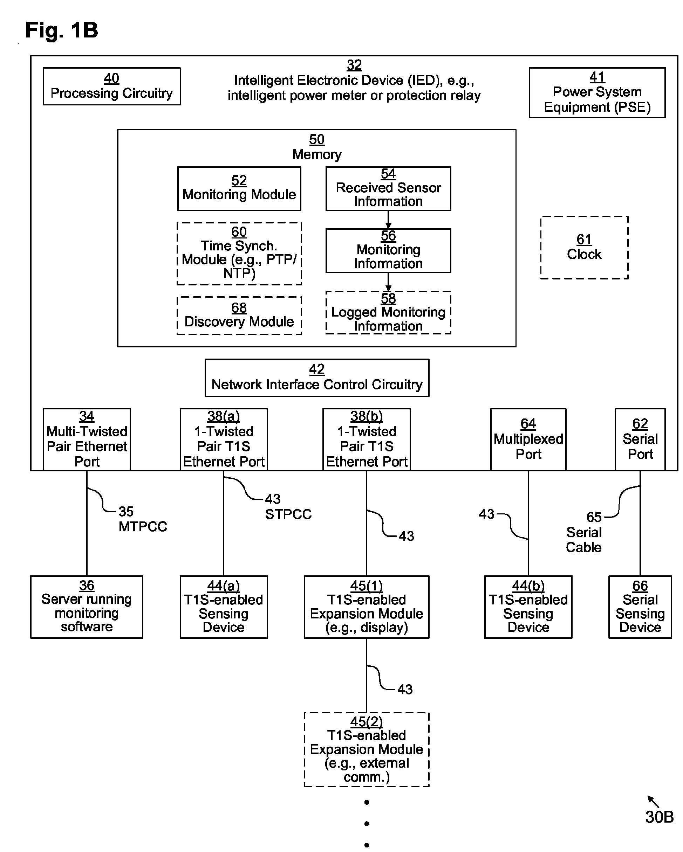

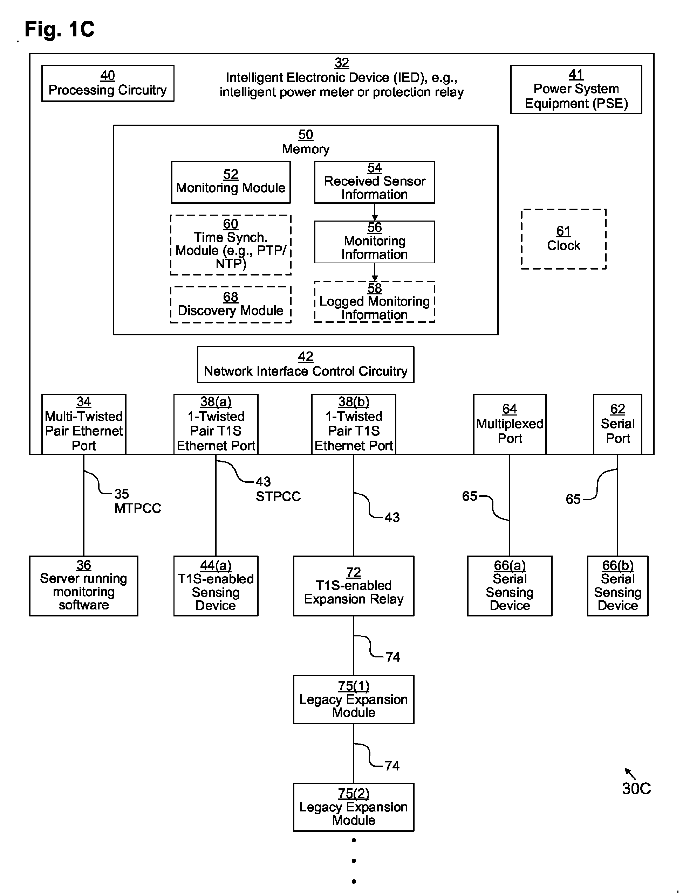

IED 32 includes a multiple twisted pair Ethernet port 34 (or, in a non-depicted embodiment, a coaxial or fiber-optical port), and a set of one or more single twisted pair T1S Ethernet ports 38 (depicted as T1S Ethernet ports 38(a), 38(b), ...). Multiple twisted pair Ethernet port 34 (or the coaxial or fiber-optical port), is configured to connect to the server 36 using the MTPCC 35 (or coaxial or fiber-optical cable), and the set of one or more single twisted pair T1S Ethernet ports 38 are configured to connect to one or more T1S-enabled sensing devices 44 via the STPCC 43. IED 32 also includes network interface control circuitry 42, processing circuitry 40, power system equipment (PSE) 41, and memory 50. In some embodiments, as depicted in Figs. 1B, 1C, IED 32 also includes a serial port 62 and/or a multiplexed serial/T1S port 64.

Network interface control circuitry 42 controls network connections via Ethernet ports 34, 38, 64. Network interface control circuitry 42 may include one or more Media Access Control (MAC) blocks (not depicted).

Processing circuitry 40 may include any kind of processor or set of processors configured to perform operations, such as, for example, a microprocessor, a multi-core microprocessor, a central processing unit (CPU), a digital signal processor, a field-programmable gate array (FPGA), a system on a chip (SoC), a collection of electronic circuits, a similar kind of controller, or any combination of the above. In an example embodiment, processing circuitry 40 may be a ZynQ UltraScale+ (US+) MPSoC, such as a ZynQ US+ ZU2CG chip provided by Xilinx/AMD of San Jose, California.

PSE 41 is circuitry configured to receive and interpret power signals and to issue control commands to electronic devices.

Memory 50 may include any kind of digital system memory, such as, for example, random access memory (RAM). Memory 40 may store an operating system (OS, not depicted, e.g., a Linux, UNIX, or similar operating system) and various drivers and other applications and software modules configured to execute on processing circuitry 40 as well as various data.

IED 32 is configured to operate as a gateway between an Ethernet connection to server 36 and T1S connections 38, 64 to T1S-enabled sensing devices 44.

T1S-enabled sensing devices 44 are power (or water, air, gas, steam, and/or any other measurable utility) metering or electrical measurement devices that have single twisted pair T1S Ethernet ports (not depicted) allowing them to connect to IED 32 or other T1S-enabled sensing devices 44 via STPCC 43. T1S-enabled sensing devices 44 may record digital signals (e.g., pulse counting, input metering, etc.) or analog signals (e.g., flow rates, temperatures, pressures, rotations, fluid levels, current in a range of 4-20mA, etc.). In some arrangements, T1S-enabled sensing device 44(a) may connect to a second T1S-enabled sensing device 44(b), which itself may connect to a third T1S-enabled sensing device 44(c), which itself may connect to a fourth T1S-enabled sensing device 44(d), etc., in a daisy-chain arrangement. In some arrangements (not depicted), a chain of T1S-enabled sensing device 44 (e.g., T1S-enabled sensing devices 44(a), 44(b), 44(c), 44(d)) may all connect to IED 32 via a single multidrop STPCC 43, each T1S-enabled sensing device 44 tapping into the same STPCC 43. In some embodiments, one or more of the T1S-enabled sensing devices 44 (e.g., second T1S-enabled sensing device 44(b)) may connect to a serial sensing device 66 via a serial cable 65, allowing that serial sensing device 66 to communicate power/electrical measurements/commends with IED 32 via the chain of T1S-enabled sensing devices 44. In some embodiments, one or more of the T1S-enabled sensing devices 44 (e.g., third T1S-enabled sensing device 44(c)) may connect to a backup power supply 49, allowing that T1S-enabled sensing device 44(c) to send backup power to IED 32 via the chain of STPCC 43 using the 10Base-T1S standard. In some embodiments, the daisy chain or multidrop bus may include a supplemental power supply 48 also connected via STPCC 43. Such a supplemental T1S-enabled power supply 48 may be configured to provide power to any of the T1S-enabled sensing devices 44 along the daisy chain or multidrop bus via the STPCC 43 (e.g., using Power Over Data Line (PODL) techniques). In some embodiments, IED 32 is able to provide power to one T1S-enabled sensing device 44 over STPCC 43 using PODL, but, if more than one T1S-enabled sensing device 44 requires external power, then it must obtain that power from supplemental power supply 48.

In some embodiments, one or more of the T1S-enabled sensing devices 44 may be configured in a similar manner as IED 32, able to serve as a gateway. However, T1S-enabled sensing devices 44 may have a simpler configuration without Ethernet/T1S gateway functionality, possibly with reduced processing power or memory capacity compared to IED 32.

In some embodiments, such as depicted in Figs. 1B, 1C, in which IED 32 includes a serial port 62, IED 32 may connect to a serial sensing device 66 via a serial cable 65, allowing that serial sensing device 66 to communicate power/electrical measurements/commends with IED 32 using the serial port 62. In embodiments in which IED 32 includes a multiplexed port 64, multiplexed port 64 is configured to attach to either STPCC 43 (as in Fig. 1B) or serial cable 65 (as in Fig. 1C), allowing IED 32 to connect either to a T1S-enabled sensing device 44 (e.g., T1S-enabled sensing device 44(b), as depicted in Fig. 1B) or to a serial sensing device 66 (e.g., serial sensing device 66(b), as depicted in Fig. 1C), respectively, via multiplexed port 64.

Memory 50 stores a monitoring module 52. Monitoring module 52 operates on processing circuitry 40 to take received sensor information 54 (received from T1S-enabled sensing devices 44 and serial sensing devices 66, if any, via operation of PSE 41), to generate monitoring information 56 therefrom, and to report the generated monitoring information 56 to server 36 over the MTPCC 35 (or coaxial or fiber optical) connection. In some embodiments, monitoring module 52 may also log some or all of the monitoring information 56 as logged monitoring information 58. In some embodiments, logged monitoring information 58 is logged only while main power supply 47 is offline and IED 32 is receiving backup power from backup power supply 49 via one of the T1S-enabled sensing devices 44, during which time monitoring module 52 temporarily refrains from reporting the generated monitoring information 56 to server 36; in such instances, monitoring module 52 reports the logged monitoring information 58 to server 36 upon the resumption of a normal supply of power from main power supply 47.

In some embodiments, as depicted in Fig. 1B, monitoring module 52 also reports a subset of the monitoring information 56 to one or more T1S-enabled expansion modules 45 (depicted as T1S-enabled expansion modules 45(1), 45(2), ...) connected to IED 32 via one of the single twisted pair T1S Ethernet ports 38 (e.g., single twisted pair T1S Ethernet port 38(b)). In other embodiments, as depicted in Fig. 1C, monitoring module 52 also reports a subset of the monitoring information 56 to one or more legacy-style expansion modules 75 (depicted as legacy expansion modules 75(1), 75(2), ...) connected to IED 32 via a T1S-enabled expansion relay 72 connected to one of the single twisted pair T1S Ethernet ports 38 (e.g., single twisted pair T1S Ethernet port 38(b)). T1S-enabled expansion relay 72 connects to legacy-style expansion modules 75 via a legacy bus 74. In some embodiments, one or more of the expansion modules 45, 75 (e.g., T1S-enabled expansion module 45(1)) may include a display screen, which may be any kind of display, including, for example, a CRT screen, LCD screen, LED screen, etc., allowing the subset of the monitoring information 56 to be displayed on that screen. In some embodiments, an expansion module 45, 75 having a display screen may also include one or more user input devices, such as a keyboard, a button, a trackball, a trackpad, etc., configured to receive user feedback. In some embodiments, one or more of the expansion modules 45, 75 (e.g., T1S-enabled expansion module 45(2)) may include an external communication port or wireless communication transceiver configured to forward the subset of the monitoring information 56 to a recipient outside of system 30B, 30C, such as a vendor, a client, or a billing system. In some embodiments, one or more of the T1S-enabled expansion modules 45 may receive power from a supplemental power supply 48.

The monitoring information 56 may include composite energy-related parameters, such as, for example, one or more of peak power, average power, power demand, voltage frequency, peak voltage, average voltage, peak current, average current, current demand, voltage/current harmonics, voltage/current unbalance, voltage sags/swell, voltage/current interruptions, etc. In some embodiments, monitoring information 56 may be generated and reported (or logged) periodically, e.g., every 1 second.

In some embodiments, one or more of the T1S-enabled sensing devices 44 or T1S-enabled expansion modules 45 may function as a signal generator configured to inject a random or semi-random signal between ground and an electrical network or power grid and to also send that signal back to the IED 32 so that the IED 32 can determine whether that signal is leaking into the electrical network or power grid with reference to measurements made of that electrical network or power grid by either the IED 32 or another T1S-enabled sensing device 44.

In some embodiments, memory 50 also stores a time synchronization module 60. Time synchronization module 60 operates on processing circuitry 40 to perform a time synchronization procedure. This time synchronization procedure may allow a clock 61 of the IED 32 to be kept very closely synchronized to clocks (not depicted) on the T1S-enabled sensing devices 44. In some embodiments, the Precision Time Protocol (IEEE 1588-2008 or 1588-2019) or a similar protocol may be used to achieve a synchronization that is precise to within 5 milliseconds (ms). In some embodiments, the synchronization may be further precise to within 1 ms or 100 nanoseconds (ns). In some embodiments, time synchronization module 60 may timestamp transitions (such as status signal changes from other equipment, such as whether an external circuit breaker is open or closed) or energy usage data (such as energy data transmitted via energy pulse outputs of other equipment) within the received sensor information 54. The time synchronization module 60 can record the exact time of input transitions and then correlate them in time with power usage data, waveform recording, or other measurements performed by IED 32 for sequence of event recording (SER). The time synchronization module 60 can also receive digital pulse information from the T1S-enabled sensing devices 44.

In some embodiments, memory 50 also stores a discovery module 68. Discovery module 68 operates on processing circuitry 40 to perform an automatic discovery and configuration procedure 70. The automatic discovery and configuration procedure 70 identifies new T1S-enabled sensing devices 44 connected to the IED 32 (either directly to one of the T1S Ethernet ports 38, 64 or indirectly via daisy chaining) and configures them automatically.

Memory 50 may also store various other data structures used by the OS, monitoring module 52, time synchronization module 60, discovery module 68, and various other applications and drivers. In some embodiments, memory 50 may also include a persistent storage portion. Persistent storage portion of memory 50 may be made up of one or more persistent storage devices, such as, for example, magnetic disks, flash drives, solid-state storage drives, or other types of storage drives. Persistent storage portion of memory 50 is configured to store programs and data even while the IED 32 is powered off. The OS, monitoring module 52, time synchronization module 60, discovery module 68, and various other applications and drivers are typically stored in this persistent storage portion of memory 50 so that they may be loaded into a system portion of memory 50 upon a system restart or as needed. The OS, monitoring module 52, time synchronization module 60, discovery module 68, and various other applications and drivers, when stored in non-transitory form either in the volatile or persistent portion of memory 50, each form a computer program product. The processing circuitry 40 running one or more applications thus forms a specialized circuit constructed and arranged to carry out the various processes described herein.

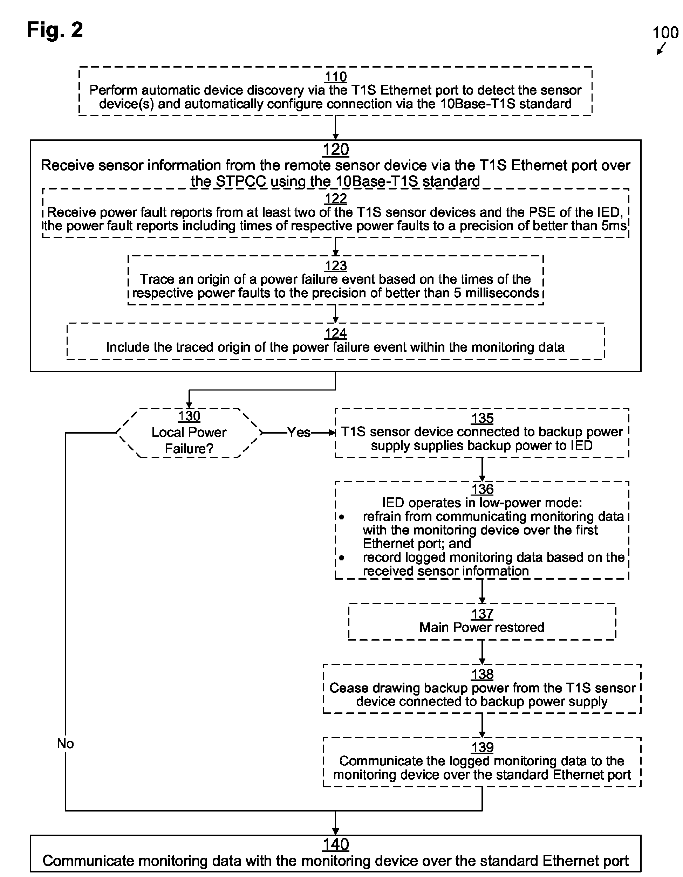

Fig. 2 illustrates an example method 100 performed by a system 30A, 30B, 30C for performing dynamic monitoring of electronic equipment using T1S-enabled sensing devices 44 attached to an IED 32. It should be understood that any time a piece of software (e.g., OS, monitoring module 52, time synchronization module 60, discovery module 68, etc.) is described as performing a method, process, step, or function, what is meant is that a computing device (e.g., IED 32) on which that piece of software is running performs the method, process, step, or function when executing that piece of software on its processing circuitry 40. It should be understood that one or more of the steps or sub-steps of method 100 may be omitted in some embodiments. Similarly, in some embodiments, one or more steps or sub-steps may be combined together or performed in a different order. Dashed lines indicate that a step or sub-step is either optional or representative of alternate embodiments or use cases.

In step 110, in some embodiments, discovery module 68 performs automatic device discovery via one or more T1S (or T1L) Ethernet port(s) 38, 64 to detect all T1S-enabled sensing devices 44 that are connected thereto (either directly or indirectly along a T1S daisy chain), automatically configuring connections to the discovered T1S-enabled sensing devices 44 via the 10Base-T1S standard (procedure 70).

In step 120, monitoring module 52 receives sensor information 54 (e.g., via PSE 41) from the T1S-enabled sensing devices via the one or more T1S Ethernet port(s) 38, 64 over the STPCC 43 using the 10Base-T1S standard. In some embodiments, step 120 includes generating monitoring information 56 based on the received sensor information 54 (e.g., averaging values out over a reporting period, performing analysis on subsets of the received sensor information 54, etc.).

In some instances, step 120 may include sub-steps 122, 123, 124. In sub-step 122, monitoring module 52 (and time synchronization module 60) receives power fault reports (not depicted) from at least two of the T1S-enabled sensing devices 44 and/or the PSE 41, the power fault reports including times of respective power faults to a precision of better than 5 ms. Thus, for example, a power fault report from the PSE 41 might be time-stamped at time T, while a power fault report from T1S-enabled sensing device 44(d) might be time-stamped at time *T* + 5 ms, a power fault report from T1S-enabled sensing device 44(c) might be time-stamped at time *T +* 13 ms, a power fault report from T1S-enabled sensing device 44(b) might be time-stamped at time *T* + 15 ms, a power fault report from T1S-enabled sensing device 44(a) might be time-stamped at time *T +* 19 ms, and a power fault report from T1S-enabled sensing device 44(e) might be time-stamped at time *T +* 10 ms.

In sub-step 123, monitoring module 52 traces the origin of a power failure event based on the times of the respective power faults from sub-step 122. For example, monitoring module 52 may take a topology and/or graph of monitored electronic devices as well as a topology and/or graph of the connections between the T1S-enabled sensing devices 44 into account when comparing the timestamps to triangulate the location of the original power failure event. Step 123 may include performing alarm alignment.

In sub-step 124, monitoring module 52 includes the traced origin of the power failure event within the monitoring information 56.

In some embodiments, sub-steps 122-124 may be performed by monitoring server 36.

In some embodiments, monitoring module 52 or monitoring server 36 may also monitor (step 130) for a local power failure (i.e., a failure of local main power supply 47). If no local power failure is detected, operation proceeds normally with step 140. Otherwise, operation proceeds with steps 135-139.

In step 135, a T1S-enabled sensing device 44(X) (e.g., T1S-enabled sensing device 44(c)) that is connected to a backup power supply 49 supplies backup power to the IED 32 via the STPCC 43 (the power passively passing through any intervening T1S-enabled sensing devices 44, such as T1S-enabled sensing devices 44(a), 44(b)). In step 136, the IED 32 operates in a low-power mode during which it (i) refrains from communicating monitoring information 56 to the server 36 and (ii) records logged monitoring information 58 based on the sensor information (or, in an alternative embodiment, it merely logs the received sensor information 58 directly). Once main power is restored in step 137, then, in step 138, IED 32 ceases to draw the backup power from the T1S-enabled sensing device 44(X) that is connected to a backup power supply 49, and in step 139, monitoring module 52 communicates the logged monitoring information 58 to the server 36 over the standard Ethernet port 34, and then proceeds to step 140. In embodiments in which only the received sensor information 58 was logged in step 136, monitoring module 52 first generates monitoring information 56 based on the logged sensor information.

In step 140, monitoring module 52 communicates the monitoring information 56 to the server 36 over the standard Ethernet port 34.

Further examples are provided in the following clauses.

Clause 1. An intelligent electronic device (IED) apparatus comprising:
power system equipment;
a first Ethernet port configured to connect to a monitoring server over one of optical fiber cable or multiple-twisted-pair copper cable (MTPCC);
a second Ethernet port configured to connect to a remote sensor device over a single-twisted-pair copper cable (STPCC) using the 10Base-T1S or -T1L standard; and
processing circuitry configured to:
   communicate monitoring data with the monitoring server over the first Ethernet port and
   receive sensor information from the remote sensor device via the second Ethernet port over the STPCC using the 10Base-T1S or -T1L standard.

Clause 2. The IED apparatus of clause 1, further comprising a serial port configured to connect to another remote sensor device over a serial bus cable, wherein the processing circuitry is further configured to receive sensor information from the other remote sensor device via the serial port over the serial bus cable.

Clause 3. The IED apparatus of clause 1, wherein:
the second Ethernet port is a multiplexed Ethernet/Serial port configured to alternatively connect to the remote sensor device over a serial bus cable; and
the processing circuitry is further configured to receive the sensor information from the remote sensor device via the multiplexed Ethernet/Serial port over the serial bus cable using a serial bus communication standard.

Clause 4. The IED apparatus of clause 1, wherein the processing circuitry is further configured to perform automatic device discovery via the second Ethernet port to detect the remote sensor device and automatically configure connection via the 10Base-T1S or -T1L standard.

Clause 5. The IED apparatus of clause 1, wherein the IED is configured to draw backup power from the remote sensor device via the second Ethernet port over the STPCC in response to a local power failure of the IED apparatus.

Clause 6. The IED apparatus of clause 5, wherein the IED is configured to operate in a low-power mode while drawing backup power from the remote sensor device via the second Ethernet port over the STPCC, the processing circuitry being configured to, while the IED operates in the low-power mode:
refrain from communicating monitoring data with the monitoring server over the first Ethernet port; and
record logged monitoring data based on the received sensor information.

Clause 7. The IED apparatus of clause 6, wherein the processing circuitry is configured to, upon restoration of local power after operating in the low-power mode:
cease drawing backup power from the remote sensor device via the second Ethernet port over the STPCC; and
communicate the logged monitoring data to the monitoring server over the first Ethernet port.

Clause 8. The IED apparatus of clause 1, wherein the processing circuitry is configured to synchronize time with the remote sensor device via the second Ethernet port over the STPCC to a precision better than 5 milliseconds.

Clause 9. A system comprising:
a sensor device having a remote Ethernet port; and
an intelligent electronic device (IED), the IED including:
   power system equipment;
   a first Ethernet port configured to connect to a monitoring server over one of optical fiber cable or multiple-twisted-pair copper cable (MTPCC);
   a second Ethernet port connected to the remote Ethernet port of the sensor device over a single-twisted-pair copper cable (STPCC) using the 10Base-T1S or -T1L standard; and
   processing circuitry configured to:
      communicate monitoring data with the monitoring server over the first Ethernet port and
      receive sensor information from the remote sensor device via the second Ethernet port over the STPCC using the 10Base-T1S or -T1L standard.

Clause 10. The system of clause 9, wherein the system further comprises a set of one or more additional sensor device(s) connected in a daisy chain or multidrop manner to the sensor device via one or more additional STPCC cables using the 10Base-T1S or -T1L standard.

Clause 11. The system of clause 10 wherein the processing circuitry of the IED is further configured to perform automatic device discovery via the second Ethernet port to detect the additional sensor device(s) of the set and automatically configure connection via the 10BaseT1S or -T1L standard.

Clause 12. The system of clause 10 wherein at least one of the sensor device or the additional sensor device(s) is connected to a backup power supply and configured to supply backup power to the IED via the STPCC in response to a local power failure of the IED apparatus.

Clause 13. The system of clause 12, wherein the IED is configured to operate in a low-power mode while drawing backup power from the at least one sensor device via the STPCC, the processing circuitry being configured to, while the IED operates in the low-power mode:
refrain from communicating monitoring data with the monitoring server over the first Ethernet port; and
record logged monitoring data based on the received sensor information.

Clause 14. The system of clause 13, wherein the processing circuitry is further configured to, upon restoration of local power after operating in the low-power mode:
cease drawing backup power from the at least one sensor device via the STPCC; and
communicate the logged monitoring data to the monitoring server over the first Ethernet port.

Clause 15. The system of clause 10 wherein at least one of the sensor device or the additional sensor device(s) includes a serial port configured to connect to another sensor device over a serial bus cable, wherein the processing circuitry is further configured to receive sensor information from the other sensor device via the STPCC and the serial bus cable.

Clause 16. The system of clause 10, wherein the processing circuitry is configured to synchronize time with the sensor device and the additional sensor device(s) via the second Ethernet port over the STPCC to a precision better than 5 milliseconds.

Clause 17. The system of clause 16, wherein the processing circuitry is configured to:
receive power fault reports from at least two of the sensor device and the additional sensor device(s), the power fault reports including times of respective power faults to the precision of better than 5 milliseconds;
trace an origin of a power failure event based on the times of the respective power faults to the precision of better than 5 milliseconds; and
include the traced origin of the power failure event within the monitoring data communicated with the monitoring server

Clause 18. The system of clause 10, wherein the system further comprises a supplemental power supply connected to the set of one or more additional sensor devices via an additional STPCC cable using the 10Base-T1S or -T1L standard, the supplemental power supply being configured to provide power to at least one of the remote sensor device and the set of one or more additional sensor devices.

Clause 19. The system of clause 9 wherein:
the system further comprises an expansion module;
the IED further includes a third Ethernet port connected to the expansion module over another STPCC using the 10Base-T1S or -T1L standard; and
the processing circuitry is further configured to communicate a subset of the monitoring data with the expansion module over the third Ethernet port

Clause 20. A method performed by an intelligent electronic device (IED) apparatus having power system equipment, the method comprising:
communicating monitoring data with a monitoring server via a first Ethernet port over one of optical fiber cable or multiple-twisted-pair copper cable (MTPCC); and
receiving sensor information from a remote sensor device via a second Ethernet port over a single-twisted-pair copper cable (STPCC) using the 10Base-T1S or -T1L standard.

Clause 21. The method of clause 19, wherein the method further comprises synchronizing time with the remote sensor device via the second Ethernet port over the STPCC to a precision better than 5 milliseconds.

While various embodiments of the invention have been particularly shown and described, it will be understood by those skilled in the art that various changes in form and details may be made therein without departing from the scope of the invention as defined by the appended claims.

It should be understood that although various embodiments have been described as being methods, software embodying these methods is also included. Thus, one embodiment includes a tangible computer-readable medium (such as, for example, a hard disk, a floppy disk, an optical disk, computer memory, flash memory, etc.) programmed with instructions, which, when performed by a computer or a set of computers, cause one or more of the methods described in various embodiments to be performed. Another embodiment includes a computer which is programmed to perform one or more of the methods described in various embodiments.

Furthermore, it should be understood that all embodiments which have been described may be combined in all possible combinations with each other, except to the extent that such combinations have been explicitly excluded.

Finally, nothing in this Specification shall be construed as an admission of any sort. Even if a technique, method, apparatus, or other concept is specifically labeled as "background" or as "conventional," Applicant makes no admission that such technique, method, apparatus, or other concept is actually prior art, such determination being a legal determination that depends upon many factors, not all of which are known to Applicant at this time.

## Claims

1. An intelligent electronic device (IED) apparatus comprising:
power system equipment;
a first Ethernet port configured to connect to a monitoring server over one of optical fiber cable or multiple-twisted-pair copper cable (MTPCC);
a second Ethernet port configured to connect to a remote sensor device over a single-twisted-pair copper cable (STPCC) using the 10Base-T1S or -T1L standard; and
processing circuitry configured to:
communicate monitoring data with the monitoring server over the first Ethernet port and
receive sensor information from the remote sensor device via the second Ethernet port over the STPCC using the 10Base-T1S or -T1L standard.

2. The IED apparatus of claim 1, further comprising a serial port configured to connect to another remote sensor device over a serial bus cable, wherein the processing circuitry is further configured to receive sensor information from the other remote sensor device via the serial port over the serial bus cable.

3. The IED apparatus of claim 1 or 2, wherein:
the second Ethernet port is a multiplexed Ethernet/Serial port configured to alternatively connect to the remote sensor device over a serial bus cable; and
the processing circuitry is further configured to receive the sensor information from the remote sensor device via the multiplexed Ethernet/Serial port over the serial bus cable using a serial bus communication standard.

4. The IED apparatus of any of the above claims, wherein the processing circuitry is further configured to perform automatic device discovery via the second Ethernet port to detect the remote sensor device and automatically configure connection via the 10Base-T1S or -T1L standard.

5. The IED apparatus of any of the above claims, wherein the IED is configured to draw backup power from the remote sensor device via the second Ethernet port over the STPCC in response to a local power failure of the IED apparatus.

6. The IED apparatus of claim 5, wherein the IED is configured to operate in a low-power mode while drawing backup power from the remote sensor device via the second Ethernet port over the STPCC, the processing circuitry being configured to, while the IED operates in the low-power mode:
refrain from communicating monitoring data with the monitoring server over the first Ethernet port; and
record logged monitoring data based on the received sensor information.

7. The IED apparatus of claim 6, wherein the processing circuitry is configured to, upon restoration of local power after operating in the low-power mode:
cease drawing backup power from the remote sensor device via the second Ethernet port over the STPCC; and
communicate the logged monitoring data to the monitoring server over the first Ethernet port.

8. The IED apparatus of any of the above claims, wherein the processing circuitry is configured to synchronize time with the remote sensor device via the second Ethernet port over the STPCC to a precision better than 5 milliseconds.

9. A system comprising:
a sensor device having a remote Ethernet port; and
the intelligent electronic device (IED) of any of claims 1-8.

10. The system of claim 9, wherein the system further comprises a set of one or more additional sensor device(s) connected in a daisy chain or multidrop manner to the sensor device via one or more additional STPCC cables using the 10Base-T1S or -T1L standard.

11. The system of claim 10 wherein at least one of the sensor device or the additional sensor device(s) is connected to a backup power supply configured to supply backup power to the IED via the STPCC in response to a local power failure of the IED apparatus.

12. The system of claim 10, wherein the processing circuitry is configured to:
receive power fault reports from at least two of the sensor device and the additional sensor device(s), the power fault reports including times of respective power faults to the precision of better than 5 milliseconds;
trace an origin of a power failure event based on the times of the respective power faults to the precision of better than 5 milliseconds; and
include the traced origin of the power failure event within the monitoring data communicated with the monitoring server.

13. The system of claim 10, wherein the system further comprises a supplemental power supply connected to the set of one or more additional sensor devices via an additional STPCC cable using the 10Base-T1S or -T1L standard, the supplemental power supply being configured to provide power to at least one of the remote sensor device and the set of one or more additional sensor devices.

14. The system of any of the claims 9 to 13 wherein:
the system further comprises an expansion module;
the IED further includes a third Ethernet port connected to the expansion module over another STPCC using the 10Base-T1S or -T1L standard; and
the processing circuitry is further configured to communicate a subset of the monitoring data with the expansion module over the third Ethernet port.

15. A method performed by an intelligent electronic device (IED) apparatus having power system equipment, the method comprising:
communicating monitoring data with a monitoring server via a first Ethernet port over one of optical fiber cable or multiple-twisted-pair copper cable (MTPCC); and
receiving sensor information from a remote sensor device via a second Ethernet port over a single-twisted-pair copper cable (STPCC) using the 10Base-T1S or -T1L standard.
